# EUROPEAN PATENT APPLICATION

(11) **EP 2 958 150 A1**
(43) Date of publication of application: **23.12.2015**
(21) Application number: 14751204.0
(22) Date of filing: 10.02.2014
(51) Int. Cl.: H01L 31/042, G02F 1/157, C03C 27/12, B60J 3/04

(54) **GLASS PANEL**

(30) Priority: 18.02.2013 JP 2013029097
(71) Applicant: Asahi Glass Company, Limited, Tokyo 100-8405 (JP)
(72) Inventor: SATO, Katsuhito, Tokyo 100-8405 (JP); KURIHARA, Kazuyuki, Tokyo 100-8405 (JP)
(74) Representative: Müller-Boré & Partner Patentanwälte PartG mbB
(86) International application number: PCT/JP2014/053092
(87) International publication number: WO 2014/126065

(57) **Abstract**

Provided is a glass panel having a glass plate with a solar battery element, which is capable of protecting a light-modulating sheet from the heat of sunlight to control a temperature increase in the light-modulating sheet.

A glass panel characterized in that a solar battery element and a light-modulating element are disposed between a first glass plate on a sunlight incident side and a second glass plate on a sunlight exit side sequentially from a first plate glass side, and a heat reflective element is interposed between the solar battery element and the light-modulating element.

## Description

### TECHNICAL FIELD

The present invention relates to a glass panel including a solar battery sheet and a light-modulating sheet, and a glass panel including a glass plate having a solar battery element, and a light-modulating sheet.

### BACKGROUND ART

Patent Document 1 discloses a roof glass panel for an automobile, including light-modulating glass and a solar battery (hereinbelow, referred to as "glass panel").

The glass panel disclosed in Patent Document 1 is configured such that a light-transmissible roof glass plate with a solar battery has light-modulating glass affixed to a car-interior side thereof. According to this glass panel, when sunlight enters the roof glass plate with a solar battery, disposed on a car-exterior side, an electromotive force is generated, and its generated power is supplied to the light-modulating glass to decrease the light transmittance of the light-modulating glass.

The roof glass plate with a solar battery is laminated glass which has a first transparent conductive film, an amorphous silicon layer and a second transparent conductive film sequentially laminated on an upper side of an inner glass plate disposed on a car-interior side, and has an outer glass plate on a car-exterior side unified to an upper side of the second transparent conductive film through a polyvinyl butyral-based interlayer.

The light-modulating glass is configured such that two glass plates having a transparent conductive film are disposed so as to make the transparent conductive films confronting each other, and that an electrochromic element (light-modulating element) is interposed between the two glass plates.

Further, Patent Document 1 recites that the light-modulating element may be formed on a car-interior side electrode of the solar battery so as to be unified as laminated glass.

In other words, Patent Document 1 discloses a glass panel which is configured such that a solar battery is disposed between an outer glass plate and an inner glass plate and that light-modulating glass is disposed on a car-interior side of the solar battery.

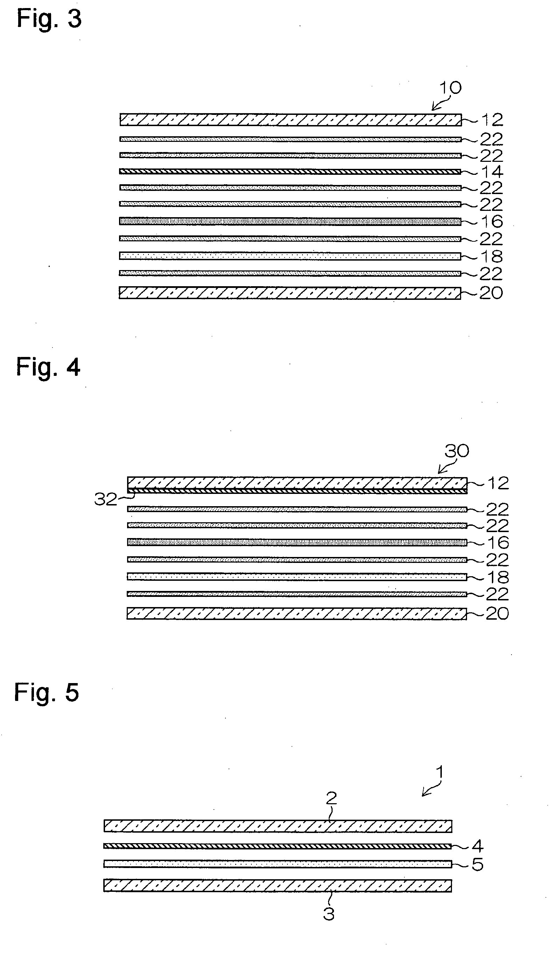

When explanation is made about the configuration of the glass panel disclosed in Patent Document 1 in reference to an accompanying drawing, the solar battery 4 is disposed between the outer glass plate 2 and the inner glass plate 3, and the light-modulating glass 5 is disposed on the car-interior of the solar battery 4 as shown in the cross-sectional view of Fig. 5 wherein the respective members forming the glass panel 1 are shown, being separated from one another.

### PRIOR ART DOCUMENT

### PATENT DOCUMENT

Patent Document 1: Full pages of the application laid open to the public under JP-U-2-38210

### DISCLOSURE OF INVENTION

### TECHNICAL PROBLEM

The glass panel disclosed in Patent Document 1, however, has caused a problem in that the temperature of the light-modulating glass 5 is increased by the heat of sunlight because the light-modulating glass 5 is directly irradiated with the sunlight transmitting through the light transmissive solar battery 4. The temperature of the light-modulating glass 5 could be increased to a temperature close to 80 to 100°C, in particular, at midsummer. When the glass panel is left for a long period of time in such a state, the light-modulating glass 5 has caused a problem of having a deteriorated performance. Further, in particular, in a case when the light-modulating element of the light-modulating glass 5 is a suspended particle device (SPD: Suspended Particle Device), it is likely that the performance of the light-modulating element is deteriorated at an early stage because the suspended particle device has an upper temperature limit of about 90 to 100°C in terms of durability.

The present invention has been proposed in consideration of the above-mentioned circumstances. It is an object of the present invention to provide a glass panel having a glass plate with a solar battery sheet or a solar battery element, which is capable of protecting a light-modulating sheet from the heat of sunlight to control a temperature increase in the light-modulating sheet.

### SOLUTION TO PROBLEM

The present invention can accomplish the above-mentioned object and is characterized as follows:
The present invention provides a glass panel including a solar battery element and a light-modulating element disposed between a first glass plate on a sunlight incident side and a second glass plate on a sunlight exit side sequentially from the first glass plate side; and a heat reflective element interposed between the solar battery element and the light-modulating element.

In one mode of the present invention, the glass panel is configured such that a solar battery sheet and a light-modulating sheet are laminated between the first glass plate on the sunlight incident side and the second glass plate on the sunlight exit side sequentially from the first glass plate side, and a heat reflective sheet is interposed between the solar battery sheet and the light-modulating sheet.

According to this one mode of the present invention, the infrared light of sunlight entering through the first glass plate and the solar battery sheet is reflected toward the solar battery sheet by the heat reflective sheet. Thus, it is possible to protect the light-modulating sheet from the heat of sunlight to control a temperature increase in the light-modulating sheet according to this one mode.

In another mode of the present invention, at least one interlayer is preferably interposed so as to form a bonding layer in each of all gaps between the first glass plate and the solar battery sheet, between the solar battery sheet and the heat reflective sheet, between the heat reflective sheet and the light-modulating sheet, and between the light-modulating sheet and the second glass sheet.

According to this mode of the present invention, the glass panel is provided as laminated glass configured such that the first glass plate and the solar battery sheet are bonded together by an interlayer, the solar battery sheet and the heat reflective sheet are bonded together by another interlayer, the heat reflective sheet and the light-modulating sheet are bonded together by another interlayer, and the light-modulating sheet and the second glass plate are bonded together by the remaining interlayer, The number of the interlayers interposed in each of positions between adjacent members (the first glass plate, the solar battery sheet, the heat reflective sheet, the light-modulating sheet and the second glass plate) can be properly determined to easily adjust the thickness of the glass panel.

In another mode of the present invention, it is preferred that the first glass plate have a principal plane formed in a three-dimensional curved shape, and that a plurality of interlayers be interposed in each of the gaps between the first glass plate and the solar battery sheet, and between the solar battery sheet and the heat reflective sheet.

According to this mode of the present invention, the plural interlayers can effectively seal a gap having irregular distance between the first glass plate having a principal plane formed in a three-dimensional shape and the solar battery sheet having a substantially flat plane. The plural interlayers can be interposed between the solar battery sheet and the heat reflective sheet as well to protect both planes of the solar battery sheet by the plural interlayers.

In another mode of the present invention, in order to attain the above-mentioned object, the glass panel is configured such that a light-modulating sheet is interposed between the first glass plate on the sunlight incident side and the second glass plate on the sunlight exit side, the first glass plate having a solar battery element, and that a heat reflective sheet is interposed between the solar battery element of the first glass plate and the light-modulating sheet.

According to this mode of the present invention, it is possible to accomplish the object of the present invention even in a mode where the first glass plate has a solar battery element formed thereon, i.e. a mode where the first glass plate is configured to be integrally formed with a solar battery element.

In another mode of the present invention, at least one interlayer is preferably interposed so as to form a bonding layer in each of the gaps between the solar battery element of the first glass plate and the heat reflective sheet, between the heat reflective sheet and the light-modulating sheet, and between the light-modulating sheet and the second glass sheet.

In another mode of the present invention, it is preferred that the first glass plate have a principal plane formed in a three-dimensional curved shape, and that a bonding layer formed by a plurality of such interlayers be interposed between the solar battery element of the first glass plate and the heat reflective sheet.

According to another mode of the present invention, particularly when the interlayer is a film made of an ethylene-vinyl acetate copolymer resin, it is possible to minimize equipment costs because it is unnecessary to carry out press-heating treatment by use of an autoclave. The use of an ethylene-vinyl acetate copolymer resin has no problem caused by a plasticizer leaking out of an interlayer, such as a problem of a plasticizer entering the light-modulating layer of the light-modulating sheet to deteriorate the inside of the light-modulating layer, because an ethylene-vinyl acetate copolymer contains no plasticizer.

In another mode of the present invention, it is preferred that the glass panel be a roof glass panel for an automobile, and that the first glass plate be disposed on a car-exterior side of an automobile while the second glass plate is disposed on a car-interior side of the automobile.

In another mode of the present invention, the glass panel is suitably utilized as a roof glass panel.

### ADVANTAGEOUS EFFECTS OF INVENTION

In accordance with the present invention, it is possible to provide a glass panel having a glass plate with a solar battery sheet or a solar battery element, which is capable of protecting a light-modulating sheet from the heat of sunlight to control a temperature increase in the light-modulating sheet.

### BRIEF DESCRIPTION OF DRAWINGS

Fig. 1 is a perspective view of the entire glass panel according to a first embodiment of the present invention;
Fig. 2 is an exploded perspective view of the glass panel shown in Fig. 1;
Fig. 3 is a schematic view showing a cross-section of the glass panel shown in Fig. 2;
Fig. 4 is a schematic view showing a cross-section of the glass panel according to a second embodiment of the present invention; and
Fig. 5 is a schematic view showing a cross-section of a conventional glass panel.

### DESCRIPTION OF EMBODIMENTS

Now, preferred embodiments of the glass panel according to the present invention will be described in reference to the accompanying drawings.

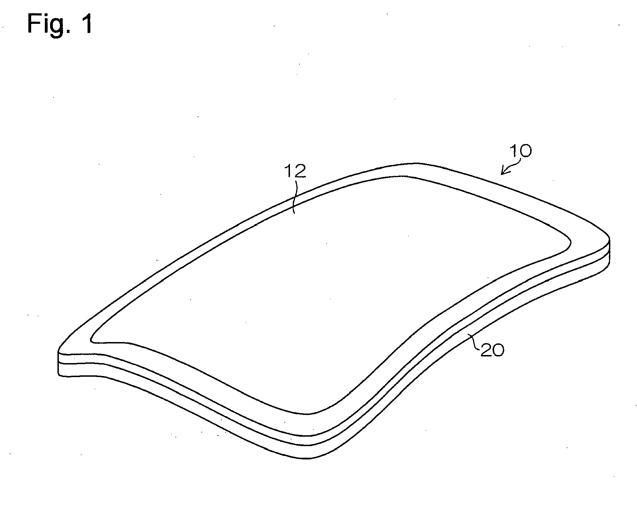

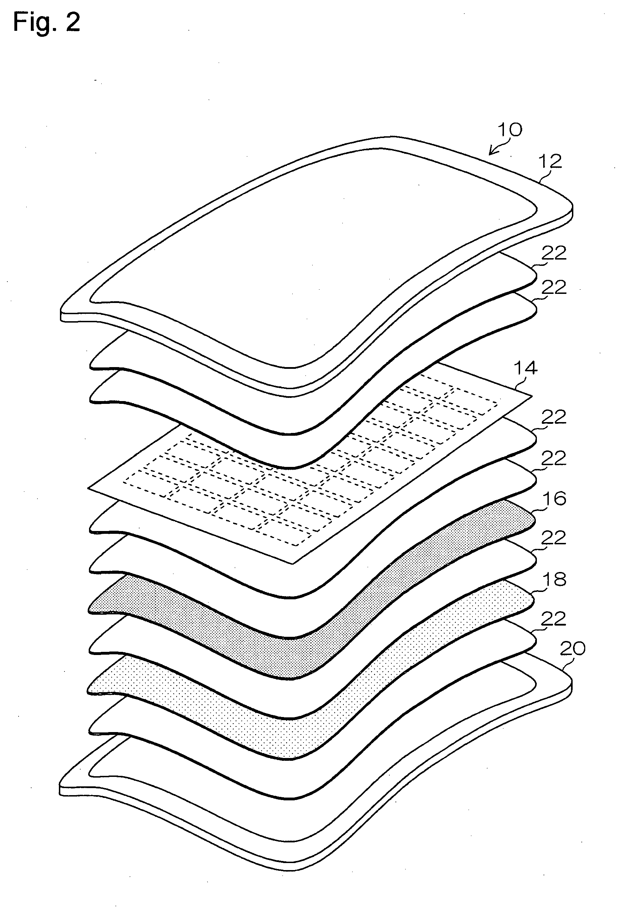

Fig. 1 is a perspective view of the entire glass panel 10 according to a first embodiment, which is applied to a roof glass panel for an automobile. Fig. 2 is an exploded perspective view of the glass panel 10, wherein the respective members constituting the glass panel 10 shown in Fig. 2 are shown to be separated from one another. Fig. 3 is a schematic view showing a cross-section of the glass panel 10 shown in Fig. 2.

First, the basic structure of the glass panel 10 will be described.

### [Basic structure of glass panel]

As shown in Figs. 2 and 3, the glass panel 10 is constituted mainly by an outer glass plate on a sunlight incident side (first glass plate) 12, a light transmissive solar battery sheet 14, a heat reflective sheet 16, a light-modulating sheet 18 and an inner glass plate on a sunlight exit side (second glass plate) 20.

Further, the glass panel 10 has two light-transmissive interlayers 22 stacked so as to form a boding layer between the outer glass plate 12 and the solar battery sheet 14 and two interlayers 22 stacked between the solar battery sheet 14 and the heat reflective sheet 16 as well. Furthermore, an interlayer 22 is disposed between the heat reflective sheet 16 and the light-modulating sheet 18, and an interlayer 22 is disposed between the light-modulating sheet 18 and the inner glass plate 20 as well.

In other words, the glass panel 10 is configured as laminated glass including the above-mentioned respective members 12 to 20 and the six interlayers 22, 22···. It should be noted that when the glass panel 10 is assembled to an opening formed in the roof of an unshown vehicle, the outer glass plate 12 is exposed on a car-exterior side while the inner glass plate 20 is exposed on a car-interior side.

### [Outer glass plate and inner glass plate]

Each of the outer glass plate 12 and the inner glass plate 20 forming the glass panel 10 may be normal float glass or tempered glass subjected to tempering by air quenching or chemical tempering. As an example, the outer glass plate 12 has a thickness of 1.8 to 3.9 mm while the inner glass plate has a thickness of 0.5 to 2.5 mm.

### [Interlayer]

Each of the interlayers 22 serving as the bonding layers of the glass panel 10 is flexible and is preferably a polyvinyl butyral-based interlayer employed in laminated glass having an excellent penetration resistance (hereinbelow, referred to as "PVB-based interlayer") or an interlayer made of an ethylene-vinyl acetate copolymer resin (hereinbelow, referred to as "EVA-based interlayer").

With regard to the interlayers 22, ones having various kinds of thicknesses are available. The use of such interlayers has advantages of not only being capable of easily adjusting the thickness of the glass panel 10 but also achieving a penetration resistance, an impact resistance and a scatter-prevention performance by stacking interlayers 22, 22··· having the same thickness or different thicknesses.

In particular, when the glass panel 10 is employed as a roof glass panel for an automobile, the outer glass plate 12 has a principal plane formed in a three-dimensional shape so as to extend along the ceiling surface of a vehicle, which forms a gap having an irregular distance between the outer glass plate 12 and the solar battery sheet 14 having a flat substrate sheet made of glass. Although it is difficult to seal such a gap by use of a single interlayer 22, it is possible to effectively seal such a gap by stacking a plurality of interlayers 22, 22··· having the same thickness or different thicknesses (two interlayers in Figs. 2 and 3) and heat-bonding the interlayers together to form a bonding layer. When a plurality of interlayers 22, 22··· (two interlayers in Figs. 2 and 3) are interposed between the solar battery sheet 14 and the heat reflective sheet 16 as well to form a bonding layer in conjunction with such arrangement, the solar battery sheet 14 has an improved durability because of having both sides protected with the bonding layers constituted by the interlayers 22, 22···.

For another reason, it is preferred that a bonding layer formed by a plurality of interlayers 22, 22··· be interposed in each of the positions between the outer glass plate 12 and the solar battery sheet 14, between the solar battery sheet 14 and the heat reflective sheet 16, between the heat reflective sheet 16 and the light-modulating sheet 18 and between the light-modulating sheet 18 and the inner glass plate 20. This is because the difference in the amounts of thermal expansion between the outer glass plate 12 and the solar battery sheet 14, the difference in the amounts of thermal expansion between the solar battery sheet 14 and the heat reflective sheet 16, the difference in the amounts of thermal expansion between the heat reflective sheet 16 and the light-modulating sheet 18 and the difference in the amounts of thermal expansion between the light-modulating sheet 18 and the inner glass plate 20, which are caused in the manufacturing process of the glass panel 10 and the use environment of the glass panel 10, can be absorbed at the interfaces between the plurality of interlayers 22, 22··· forming the bonding layers.

When an attempt is made to absorb a difference in the amounts of thermal expansion at the interface between a surface of the bonding layer formed by an interlayer 22 and, e.g. the solar battery cell of the solar battery sheet 14, it is likely that the interlayer 22, which has a greater amount of thermal expansion than the cell, places a load on the cell to damage the cell. This embodiment is free from the problem of damaging the cell because the difference in the amounts of thermal expansion is absorbed at the interfaces between the plurality of interlayers 22, 22···.

Further, because the bonding layers formed by the plurality of interlayers 22, 22··· exhibit a buffering function when the respective members 12 to 20 forming the glass panel 10 are laminated, it is possible to prevent the respective members 12 to 20 from being damaged, which could otherwise occur when the respective members 12 to 20 are laminated. The operation for laminating the plurality interlayers 22, 22··· is easy because it is sufficient to merely stacking the plurality interlayers 22, 22···. Each of the interlayers 22 has a thickness of 0.1 to 1.0 mm for example.

When an end face of the glass panel 10 is exposed, the bonding layers are preferably EVA-based interlayers having a higher water resistance (smaller influence from water) than the PVB-based interlayers. Further, the EVA-based interlayers are advantageous in terms of production cost because of being capable of dispensing with an autoclave and having excellent adhesiveness and transparency. Furthermore, when each of the outer glass plate 12 and the inner glass plate 20 is chemically tempered glass, the EVA-based interlayers have a good adhesiveness, having an advantage of being difficult in peel from each of the outer glass plate 12 and the inner glass plate 20.

### [Solar battery sheet]

The solar battery cell included in the solar battery sheet 14 may be, for example, made of gallium-arsenide, silicon single crystal, polycrystalline silicon, amorphous silicon, CIS or CIGS. A semiconductor thin film having a high transparency, such as a thin film made of amorphous silicon, is preferred in terms of light transmission.

When the solar battery sheet 14 is a solar battery sheet made of amorphous silicon, the solar battery sheet may be produced by coating a transparent conductive film on a glass substrate sheet so as to form an electrode, coating an amorphous silicon film on the conductive film, and coating a transparent conductive film on the amorphous silicon film so as to serve as a counter electrode. The solar battery sheet 14 has a thickness of 0.1 to 1.5 mm for example.

### [Heat reflective sheet]

Although the heat reflective sheet 16 may be, for example, a sheet produced by forming, on a transparent sheet made of polyethylene terephthalate (PET), etc., a transparent heat reflective layer reflecting infrared rays (such as, a metal layer made of silver, etc.), the heat reflective sheet is not limited to the just above mentioned one.

In other words, any sheet is applicable as the heat reflective sheet 16 as long as it has a function of reflecting infrared rays of solar light to control a temperature increase in the light-modulating sheet 18. Examples of the heat reflective sheet include a heat reflective layer formed by alternately laminating oxide layers and metal layers on a transparent sheet and a heat reflective layer formed by alternatively laminating high refractive index layers and low refractive index layers. The heat reflective layer may be disposed so as to face the solar battery sheet 14 or the light-modulating sheet 18.

The higher the infrared reflectivity of the heat reflective layer is, the more it is preferred. The heat reflective layer normally has a heat reflectivity of about 40 to 50%. The heat reflective layer can sufficiently control a temperature increase in the light-modulating sheet 18, even having such a degree of heat reflectivity. For example, the heat reflective sheet 16 has a thickness of preferably 0.01 to 0.20 mm, more preferably 0.01 to 0.15 mm.

### [Light-modulating sheet]

Various kinds of sheets may be applicable to the light-modulating sheet 18. A suspended particle device (SPD) as one example of the light-modulating sheet 18 is produced by disposing, between two polyethylene terephthalate (PET) films with a transparent conductive film coated on each of the films, a droplet having a diameter of several micrometers with dispersed particles capable of being subjected to alignment therein, and aligning the particles by transmission/stop of electric signals such that the light transmission can be controlled so as to switch between a deep blue state and a transparent state.

The light-modulating sheet 18 may be, for example, a known sheet having an electrochromic element (light-modulating element) between two transparent substrates or a known sheet having a liquid crystal element (light-modulating element) encapsulated therein. For example, the light-modulating sheet 18 has a thickness of 0.2 to 0.8 mm.

### [Process for producing glass panel]

In the process for producing a glass panel 10 employing PVB-based interlayers as the interlayers 22, the respective members 12 to 20 and the plurality of interlayers 22, 22··· are laminated to form a laminate, the laminate is encapsulated in a vacuum bag, and the laminate is preliminarily heated at about 130°C, being encapsulated in the vacuum bag. After that, the laminate thus preliminarily heated is pressurized, being heated at a temperature of 100 to 150°C by use of a known autoclave. Thus, the glass panel 10 employing PVB-based interlayers is produced.

On the other hand, in the process for producing a glass panel 10 employing EVA-based interlayers as the interlayers 22, it is unnecessary to carry out press-heating treatment by use of the autoclave. Specifically, the glass panel may be produced by laminating the respective members 12 to 20 and the plurality of interlayers 22, 22··· to form a laminate, encapsulating the laminate in a vacuum bag, and immersing the vacuum bag in hot water having a temperature of about 90°C for heating for example.

The use of PVB-based interlayers has a problem of increasing equipment cost because it is necessary to carry out treatment by use of an autoclave. Further, the presence of a plasticizer contained in PVB leads to a case where a plasticizer, which has leaked out of a PVB-based interlayer, enters the light-modulating layer (light-modulating element) of the light-modulating sheet 18 to deteriorate the inside of the light-modulating layer, in some cases.

To the contrast, the use of EVA-based interlayers can minimize equipment cost because it is unnecessary to carry out treatment by use of an autoclave. The use of EVA-based interlayers has an advantage of being free from the above-mentioned problem caused by a plasticizer because the EVA-based interlayers contain no plasticizer. For these reasons, it is preferred to employ EVA-based interlayers as the interlayers 22.

Further, such EVA-based interlayers have an advantage of being capable of employing, as the light-modulating sheet 18, a suspended particle device (SPD) having a lower durability in a high temperature range because the production of the glass panel 10 has an upper temperature limit of about 100°C.

Now, explanation will be made about the main features of the glass panel 10 according to the first embodiment.

### [Features of glass panel]

The glass panel 10 according to the first embodiment is configured so as to have the heat reflective sheet 16 interposed between the solar battery sheet 14 and the light-modulating sheet 18. This arrangement allows the infrared light of sunlight entering through the outer glass plate 12 and the solar battery sheet 14 to be reflected toward the solar battery sheet 14 by the heat reflective sheet 16. Thus, the glass panel 10 according to the first embodiment can protect the light-modulating sheet 18 from the heat of sunlight to control a temperature increase in the light-modulating sheet 18 (temperature increase to 10 to 20°C for example).

In the glass panel 10 according to the first embodiment, at least one interlayer 22 is interposed in each of the gaps between the outer glass plate 12 and the solar battery sheet 14, between the solar battery sheet 14 and the heat reflective sheet 16, between the heat reflective sheet 16 and the light-modulating sheet 18, and between the light-modulating sheet 18 and the inner glass plate 20.

Thus, in accordance with the glass panel 10 of the first embodiment, it is possible to provide a glass panel as laminated glass configured such that the outer glass plate 12 and the solar battery sheet 14 are bonded together with an interlayer 22, the solar battery sheet 14 and the heat reflective sheet 16 are bonded together by another interlayer 22, the heat reflective sheet 16 and the light-modulating sheet 18 are bonded together by an another interlayer 22, the light-modulating sheet 18 and the inner glass plate 20 are bonded together by the remaining interlayer 22.

Fig. 4 is a schematic view showing a cross-section of the glass panel 30 according to a second embodiment. When explanation will be made about the glass panel 30, the members identical those of the glass panel 10 shown in Fig. 1 to Fig. 3 are denoted by like reference numerals, and explanation of the members and the advantages of those members will be omitted.

The glass panel 30 shown in Fig. 4 is provided with no solar battery sheet 14 and has a solar battery element 32 integrally provided on a car-interior side of an outer glass plate 12. In other words, the glass panel 30 has a heat reflective sheet 16 interposed between the solar battery element 32 on the outer glass plate 12 and a light-modulating sheet 18. Even the glass panel 30 thus configured can obtain a similar advantage to the glass panel 10.

In the glass panel 30, at least one interlayer 22 is interposed in each of the gaps between the heat reflective sheet 16 and the solar battery element 32 on the outer glass plate 12 having a principal plane formed in a three-dimensional curved shape, between the heat reflective sheet 16 and the light-modulating sheet 18, and between the light-modulating sheet 18 and an inner glass plate 20. The interlayers 22 have a similar advantage to those of the glass panel 10. Although the solar battery element 32 may be, for example, made of gallium-arsenide, silicon single crystal, polycrystalline silicon, amorphous silicon, CIS or CIGS, a semiconductor thin film having a high transparency, such as a thin film made of amorphous silicon, is preferred in terms of light transmission.

### INDUSTRIAL APPLICABILITY

Although, in these embodiments, the glass panel 10 applied to a roof glass panel for an automobile is exemplified as the glass panel according to the present invention, the glass panel according to the present invention is not limited to such an application. For example, the glass panel according to the present invention may be applied to window glass for a building, window glass for an airplane, a railroad car, a ship, etc., or a glass panel installed as a fence at a passage, a balcony, a veranda, etc. in a building where a sunlight is take in. In those cases, the outer glass plate 12 is disposed on a sunlight incident side while the inner glass plate 20 is disposed on a sunlight exit side.

The entire disclosure of Japanese Patent Application No. 2013-029097 filed on February 18, 2013 including specification, claims, drawings and summary is incorporated herein by reference in its entirety.

### EXPLANATION OF SYMBOLS

- 10:: Glass panel
- 12:: Outer glass plate
- 14:: Solar battery sheet
- 16:: Heat reflective sheet
- 18:: Light-modulating sheet
- 20:: Inner glass plate
- 22:: Interlayer
- 30:: Glass panel
- 32:: Solar battery element

## Claims

1. A glass panel comprising a solar battery element and a light-modulating element disposed between a first glass plate on a sunlight incident side and a second glass plate on a sunlight exit side sequentially from a first glass plate side; and a heat reflective element interposed between the solar battery element and the light-modulating element.

2. The glass panel according to Claim 1, wherein a solar battery sheet and a light-modulating sheet are laminated between the first glass plate on the sunlight incident side and the second glass plate on the sunlight exit side sequentially from the first glass plate side, and a heat reflective sheet is interposed between the solar battery element and the light-modulating sheet.

3. The glass panel according to Claim 2, further comprising at least one interlayer interposed so as to form a bonding layer in each of all gaps between the first glass plate and the solar battery sheet, between the solar battery sheet and the heat reflective sheet, between the heat reflective sheet and the light-modulating sheet, and between the light-modulating sheet and the second glass sheet.

4. The glass panel according to Claim 3, wherein the first glass plate has a principal plane formed in a three-dimensional curved shape; and
a plurality of such interlayers are interposed in each of the gaps between the first glass plate and the solar battery sheet, and between the solar battery sheet and the heat reflective sheet.

5. The glass panel according to Claim 1, wherein a light-modulating sheet is interposed between the first glass plate on the sunlight incident side and the second glass plate on the sunlight exit side, the first glass plate having a solar battery element; and a heat reflective sheet is interposed between the solar battery element of the first glass sheet and the light-modulating sheet.

6. The glass panel according to Claim 5, further comprising at least one interlayer interposed so as to form a bonding layer in each of all gaps between the solar battery element of the first glass plate and the heat reflective sheet, between the heat reflective sheet and the light-modulating sheet, and between the light-modulating sheet and the second glass sheet.

7. The glass panel according to Claim 6, wherein the first glass plate has a principal plane formed in a three-dimensional curved shape; and
a plurality of such interlayers interposed between the solar battery element of the first glass plate and the heat reflective sheet.

8. The glass panel according to Claim 3, 4, 6 or 7, wherein the interlayers are made of an ethylene-vinyl acetate copolymer resin.

9. The glass panel according to any one of Claims 1 to 8, which comprises a roof glass panel for an automobile, the first glass plate being disposed on a car-exterior side of the automobile while the second glass plate is disposed on a car-interior side of the automobile.
